(19) Europäisches Patentamt
European Patent Office
Office européen des brevets

(11) **EP 3 855 586 B1**

(12) **EUROPEAN PATENT SPECIFICATION**

(45) Date of publication and mention
of the grant of the patent:
**19.04.2023  Bulletin 2023/16**

(21) Application number: **18937941.5**

(22) Date of filing: **22.10.2018**

(51) International Patent Classification (IPC):
*H01S 5/14* *(2006.01)*     *G03B 21/14* *(2006.01)*
*H01S 5/02325* *(2021.01)*     *G03B 21/20* *(2006.01)*
*H01S 5/02326* *(2021.01)*     *H01S 5/028* *(2006.01)*
*H01S 5/40* *(2006.01)*

(52) Cooperative Patent Classification (CPC):
**G03B 21/2033; G03B 21/206; H01S 5/02326;
H01S 5/0239; H01S 5/143;** H01S 5/0287;
H01S 5/4062; H01S 5/4068; H01S 5/4087

(86) International application number:
**PCT/JP2018/039145**

(87) International publication number:
**WO 2020/084652 (30.04.2020 Gazette 2020/18)**

(54) **LASER DEVICE**

LASERVORRICHTUNG

DISPOSITIF LASER

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**28.07.2021  Bulletin 2021/30**

(73) Proprietor: **Mitsubishi Electric Corporation**
**Tokyo 100-8310 (JP)**

(72) Inventors:
• **SHOHDA, Fumio**
**Tokyo 100-8310 (JP)**
• **YANAGISAWA, Takayuki**
**Tokyo 100-8310 (JP)**

• **KAMEYAMA, Shumpei**
**Tokyo 100-8310 (JP)**

(74) Representative: **Pfenning, Meinig & Partner mbB**
**Patent- und Rechtsanwälte**
**Joachimsthaler Straße 10-12**
**10719 Berlin (DE)**

(56) References cited:
JP-A- H07 240 558     JP-A- H11 186 648
JP-A- 2004 128 072     JP-A- 2008 130 805
JP-A- 2009 117 746     JP-A- 2012 142 432
JP-A- 2015 072 955     JP-A- 2016 054 295
JP-B2- S6 211 237     US-A1- 2005 068 996
US-A1- 2006 227 821     US-A1- 2007 291 812
US-A1- 2018 026 425     US-B1- 6 192 062

## Description

TECHNICAL FIELD

The present invention relates to a laser device.

BACKGROUND ART

A laser device which is a light source with high directivity is used for applications such as measurement of distance, but is also used as a light source for a projector due to an advantage of its high efficiency. For example, Patent Literature 1 discloses a projector using a laser light source. In the projector, a technique is disclosed in which incident light is split into a plurality of optical paths by an optical element disposed in an optical path of laser light, and the phases of the respective pieces of split light are individually changed by the optical element provided in the optical paths of the respective pieces of split light, thereby suppressing the occurrence of a speckle pattern appearing on a screen.
Patent Literature 3 discloses a semiconductor laser oscillator including laser modules, a collimating lens, a diffraction grating performing beam coupling for the lasers emitted from the collimating lens and an incident angle varying mechanism to change the incident angles at which the lasers are incident onto the grating. Patent Literature 4 also discloses laser resonator in which the incident angle of collimated light is varied by movement of an adjustment lens. Patent Literature 5 discloses a similar system for beam coupling in a fiber laser. Patent Literature 6 discloses a tunable laser that has a grating tuning element rotatable about a pivot axis formed by a flexure pivot or hinge.

CITATION LIST

PATENT LITERATURES

Patent Literature 1: JP 2013-44800 A
Patent Literature 2: JP 6165366 B2
Patent Literature 3: US 2018/026425 A1
Patent Literature 4: JP 2008-130805 A
Patent Literature 5: JP 2015-072955 A
Patent Literature 6: US 2006/227821 A1

SUMMARY OF INVENTION

TECHNICAL PROBLEM

In a conventional laser device such as that described above, the wavelength of oscillation is uniquely determined by a medium or a component. For example, in a semiconductor laser device, the wavelength of oscillation is uniquely determined by a material of a medium or the characteristics of films formed on end surfaces of a laser chip.

However, there is a case in which when a laser light source is applied to a product such as a projector, the wavelength of oscillation needs to be changed. For example, there is a case in which there is a need of a laser light source that emits red light with a wavelength having a high luminosity factor which is an index of human eye's perception of brightness in a red band, i.e., red light on a short wavelength side in the red band. Alternatively, there is a case in which in order to adjust the color balance of three primary colors of light emitted from a projector, there is a need to slightly change each wavelength in a band of each color in a laser light source that emits blue, green, and red.

The conventional laser device does not allow a user to change the wavelength of oscillation, and thus, there is a need to select a laser light source that emits light with a wavelength close to a desired wavelength of oscillation from limited ready-made products, or to design and produce a laser device that emits light with a desired wavelength of oscillation.

The present invention is made to solve a problem such as that described above, and an object of the present invention is to obtain a laser device that allows a user of the laser device to change the wavelength of oscillation.

SOLUTION TO PROBLEM

This problem is solved by a laser device according to claim 1. In particular a laser device according to the present invention includes: a light source unit provided with a laser element for emitting laser light by forming a laser resonator with an output mirror, the laser element having a rear end surface on which a reflective film is formed; an optical element for determining a wavelength of oscillation emitted from the laser element, on the basis of an angle of the laser light incident on the optical element, the optical element being disposed in an optical path of the laser light emitted from the light source unit, between said laser element and said output mirror; the output mirror configured to reflect a part of emission light emitted from the optical element toward the optical element; and angle-of-incidence changing means for changing an angle at which the light emitted from the light source unit is incident on the optical element, wherein the output mirror configured to allow another part of the light than the reflected light reflected toward the optical element, which is a part of the emitted light emitted from the optical element to pass therethrough and outputs the other part of the light to the outside of the laser device, the light source unit includes a first lens for refracting the light emitted from the laser element to emit parallel light, and the angle-of-incidence changing means includes a second lens having an incident surface whose area is larger than an emission area of the light emitted from the first lens, the second lens allowing the light emitted from the first lens to be incident on the incident surface to collect the light; and lens moving means configured to change the angle of the light incident on the incident surface by allowing the second lens to move to change an incident position, on the incident surface, of the light emitted from the first lens, wherein the laser device comprises an integral component unit in which the second lens, the optical element, and the output mirror are formed into one unit, and wherein the lens moving means are configured to allow the integral component unit to move in a perpendicular direction to a direction in which the output mirror outputs the light outside the laser device, by which the second lens is configured to move in a perpendicular direction to a direction in which the output mirror outputs a light outside the laser device, and the incident position changes.

ADVANTAGEOUS EFFECTS OF INVENTION

A laser device of the present invention is provided with a light source unit provided with a laser element for emitting laser light by forming a laser resonator with an output mirror, the laser element having a rear end surface on which a reflective film is formed; an optical element for determining a wavelength of oscillation emitted from the laser element, on the basis of an angle of the laser light incident on the optical element, the optical element being disposed in an optical path of the laser light emitted from the light source unit; the output mirror for reflecting a part of emission light emitted from the optical element toward the optical element; and angle-of-incidence changing means for changing an angle at which the light emitted from the light source unit is incident on the optical element, and thus, by changing the angle of incidence of light incident on the optical element by the angle-of-incidence changing means, the wavelength of light emitted from the optical element in a predetermined angular direction can be changed, and the wavelength of light that resonates between the laser element and the output mirror and is outputted from the output mirror can be changed by a user of the laser device.

BRIEF DESCRIPTION OF DRAWINGS

FIGs. 1A and 1B are configuration diagrams showing a configuration of a laser device of a first embodiment.
FIGs. 2A and 2B are explanatory diagrams showing the states of main parts upon operation of the laser device according to the first embodiment.
FIG. 3 is a characteristic diagram showing a gain band of a laser element with respect to wavelength and output light spectra upon operation of the laser device in the first embodiment.
FIGs. 4A and 4B are configuration diagrams showing a configuration of a laser device of a second embodiment.

iment.
FIG. 5 is an explanatory diagram showing the states of main parts upon operation of the laser device according to the second embodiment.
FIGs. 6A and 6B are characteristic diagrams showing a gain band of a laser element with respect to wavelength and output light intensity spectra upon operation of the laser device in the second embodiment.
FIGs. 7A and 7B are configuration diagrams showing a configuration of a laser device of a third embodiment.
FIG. 8 is an explanatory diagram showing the states of main parts upon operation of the laser device according to the third embodiment.

DESCRIPTION OF EMBODIMENTS

First Embodiment.

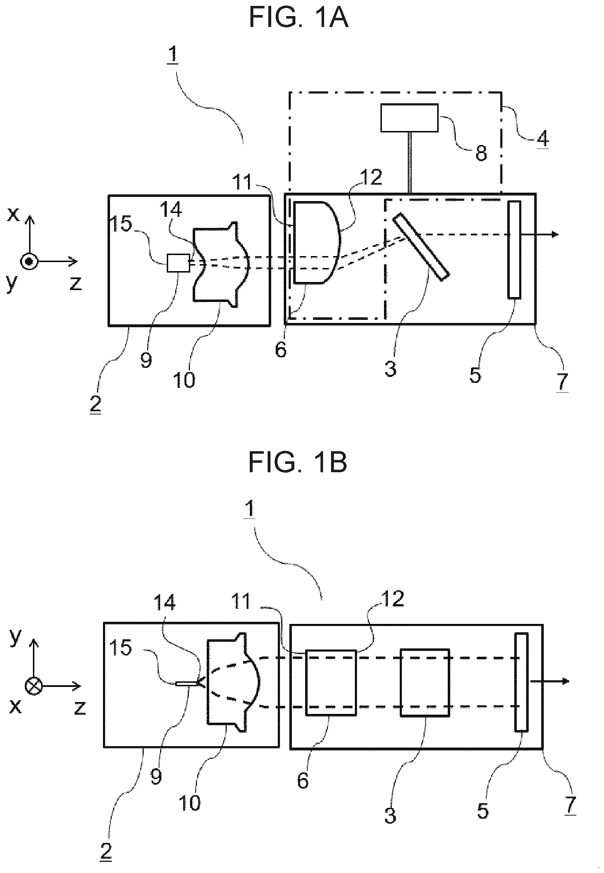

FIGs. 1A and 1B are configuration diagrams showing a configuration of a laser device 1 of a first embodiment for carrying out the present invention, and FIG. 1A is a configuration diagram of the laser device 1 as viewed from above and FIG. 1B is a configuration diagram of the laser device 1 as viewed from the side.
The laser device 1 of the first embodiment allows a user of the laser device 1 to change the angle of light that is emitted from a light source unit 2 and incident on a diffraction grating 3, using angle-of-incidence changing means 4, by which the wavelength of laser light outputted from an output mirror 5 is changed.
As shown in FIGs. 1A and 1B, the laser device 1 includes the light source unit 2 that emits parallel light; a cylindrical lens 6 that is disposed in an optical path of the parallel light emitted from the light source unit 2 and that has lensing effect in one direction in a horizontal plane, i.e., an x-direction of FIGs. 1A and 1B; the diffraction grating 3 serving as an optical element that converts light collected by the cylindrical lens 6 into emission light to be emitted in a direction based on the wavelength of the light; and the output mirror 5 that reflects a part of diffracted light emitted from the diffraction grating 3 in the direction of the diffraction grating 3 and allows the other part of the light than the reflected light to pass therethrough and outputs the other part of the light to the outside of the laser device 1.
Note that a coordinate system used in the description of the present embodiment is as follows. A direction in which light is emitted from the output mirror 5 is a positive direction of a z-axis, and an x-axis is taken in such a manner that a zx-plane coincides with the horizontal plane. A direction orthogonal to the horizontal plane is a y-axis, and positive directions of the x-axis and the y-axis are determined in such a manner that an xyz-coordinate system is a right-handed system. In addition, a coordinate origin is the center of gravity of a laser element.

The cylindrical lens 6, the diffraction grating 3, and the output mirror 5 form an integral component unit 7 in which the cylindrical lens 6, the diffraction grating 3, and the output mirror 5 are formed into one unit by being mounted on the same frame (not shown).

The integral component unit 7 has lens moving means 8 connected thereto. The lens moving means 8 allows the integral component unit 7 to move in the x-direction so that the cylindrical lens 6 moves in the x-direction. In the present embodiment, the cylindrical lens 6 and the lens moving means 8 form the angle-of-incidence changing means 4.

The laser device 1 is thus configured and each unit will be described in detail below.

The light source unit 2 includes a laser element 9 that generates light by spontaneous emission when current flows therethrough, and amplifies light by induced emission and emits the light; and a lens 10 serving as a first lens that allows the light emitted from the laser element 9 to be incident thereon and emits parallel light. The lens 10 has an incident surface that has a concave shape which is linear at a section parallel to a yz-plane and is curved at a section parallel to the zx-plane and that has lensing effect in the x-direction for rays of light to be incident thereon; and a convex-shaped emission surface that is axially symmetric with respect to an optical axis of the lens 10. By this configuration, light emitted from the laser element 9 and incident on the lens 10 is refracted in each of the x-direction and y-direction and collimated, and parallel light is emitted from the emission surface of the lens 10.

Note that the shape of the lens 10 that makes incident light parallel is disclosed in Patent Literature 2, and the shape of the lens 10 of the present embodiment is the same as the shape disclosed in Patent Literature 2. Note also that the disposition positions of the laser element 9 and the lens 10 are also disclosed in Patent Literature 2, and the laser element 9 of the present embodiment is disposed in a focal position on an incident surface side of the lens 10, as with a disposition relationship disclosed in Patent Literature 2.

The cylindrical lens 6 has an incident surface 11 whose area is larger than the emission area of light emitted from the lens 10; and an emission surface 12 having a curved shape which is linear at a section parallel to the yz-plane but is curved at a section parallel to the zx-plane. Parallel light emitted from the lens 10 passes through the cylindrical lens 6 and is thereby subjected to lensing effect in the x-direction and collected. On the other hand, the parallel light emitted from the lens 10 is not subjected to lensing effect in the y-direction.

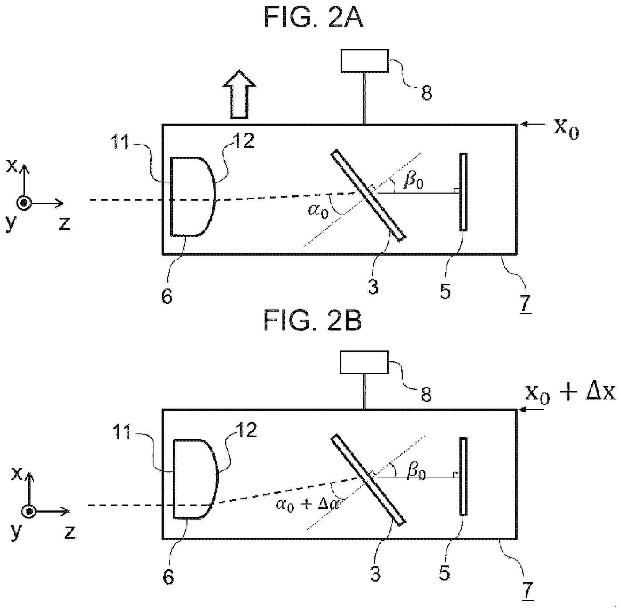

In addition, since the incident surface 11 of the cylindrical lens 6 is configured to be larger than the emission area of light emitted from the lens 10, as shown in FIGs. 2A and 2B, by a change in the position on the incident surface where parallel light emitted in parallel to a z-direction from the lens 10 is incident on the cylindrical lens 6, light emitted from the emission surface 12 of the cylindrical lens 6 changes in angle around the y-axis (has an angle in the x-direction from a z-axis direction).

As described above, the integral component unit 7 has the lens moving means 8 connected thereto, and by the lens moving means 8 allowing the integral component unit 7 to move in the x-direction, the incident position of light on the incident surface 11 is changed and the angle of emission of light emitted from the emission surface 12 of the cylindrical lens 6 changes, and as a result, an angle at which the emission light is incident on the diffraction grating 3 changes.

The cylindrical lens 6 and the lens moving means 8 that have such configurations form the angle-of-incidence changing means 4 for changing an angle at which light emitted from the light source unit 2 is incident on the diffraction grating 3. Note that in the embodiment, the lens 10 corresponds to a first lens in the claims and the cylindrical lens 6 corresponds to a second lens in the claims.

The laser element 9 is a laser chip made of a semiconductor, and has films formed on each of a front end surface 14 and a rear end surface 15. The front end surface 14 has an anti-reflective film formed thereon that has a property of allowing light with the wavelength of oscillation of laser light to pass therethrough, and the rear end surface 15 has a reflective film formed thereon that has a property of totally reflecting light with the wavelength of oscillation of laser light. The laser device 1 of the present embodiment is an external resonance type laser device in which a resonator is formed between the rear end surface 15 of such a laser element 9 and the output mirror 5. Note that it is common that a surrounding portion of the laser element includes a submount (not shown) serving as a base of the laser element, a block having the submount joined thereto, and a stem.

In addition, the laser element 9 has finite light emission widths in the x-direction and the y-direction, and the light emission width in the x-direction is normally from several micrometers to several hundred micrometers, and the light emission width in the y-direction is normally from one micrometer to several micrometers. In addition, light emitted from the laser element 9 has different spread angles in the x-direction and the y-direction. The light has a minimum spread half-angle in the x-direction, typically, 2° to 15°, and has a maximum spread half-angle in the y-direction, typically, 15° to 45°.

The lens moving means 8 allows the integral component unit 7 to move in the x-direction, and in the present embodiment, the lens moving means 8 is a micrometer. By the user of the laser device adjusting the micrometer, the position in the x-direction of the integral component unit 7 can be adjusted. The lens moving means 8 may be any means as long as the means allows the cylindrical lens 6 to move in the x-direction so that the incident position, on the incident surface 11, of light emitted from the lens 10 is changed, and the configuration is not limited to the above-described one.

The diffraction grating 3 has a plurality of slits extending in a direction parallel to the y-axis, and a straight line perpendicular to a plane formed by the extending direction and arrangement direction of the slits forms an angle $\beta_0$ with the z-axis. The diffraction grating 3 is a transmission diffraction grating in which incident light passes through the slits and is diffracted.

When components with the same wavelength out of light incident on the diffraction grating 3 are diffracted by the diffraction grating 3, the components cause interference in which they reinforce each other at a predetermined angle of emission. The angle of emission is determined by a relationship between the angle of incidence and wavelength of light to be incident. Thus, laser oscillation can be obtained at a wavelength of oscillation that is determined by the angle of laser light to be incident on the diffraction grating at a desired wavelength in a gain band of the laser element. In addition, the diffraction grating 3 of the present embodiment can obtain maximum diffraction efficiency in a specific order of diffraction $m_0$.

In addition, the diffraction grating 3 is disposed at a focal length on an emission surface side of the cylindrical lens 6. By this configuration, a laser resonator with little optical loss can be implemented.

The output mirror 5 has a film with a predetermined reflectivity formed on an incident surface thereof, and is disposed in an optical path of diffracted light and in parallel to the xy-plane, and reflects a part of incident light in the direction of the diffraction grating 3 and allows the other part of the light than the reflected light to pass therethrough and outputs the other part of the light. The light reflected by the output mirror 5 propagates in a reverse direction along the same optical path as an incident optical path, and is incident on the laser element 9 and reflected by the reflective film on the rear end surface 15 again. It is configured in such a manner that light thus is repeatedly reflected between the output mirror 5 and the reflective film on the rear end surface 15 of the laser element 9, and they form a resonator.

The laser device 1 of the present embodiment is configured as described above.

Next, operations of the laser device 1 of the present embodiment will be described. In the laser device 1 of the present embodiment, as described above, a resonator is formed in such a manner that light is repeatedly reflected between the laser element 9 and the output mirror 5, and a part of light amplified by the resonator is outputted from the output mirror 5, and the part of light is outputted as laser light. FIGs. 2A and 2B are explanatory diagrams showing the states of main parts upon operation of the laser device 1 according to the present embodiment. Upon operation of the laser device 1, when the user of the laser device 1 allows the lens moving means 8 to be driven to move the integral component unit 7 in the x-direction, a state shown in FIG. 2A is changed to a state shown in FIG. 2B, by which the angle of light incident on the diffraction grating 3 changes. In this case, too, light amplified by the resonator that forms a path in which light is repeatedly reflected between the laser element 9 and the output mirror 5 is outputted from the output mirror 5. Note, however, that the angle of light incident on the diffraction grating 3 in the state shown in FIG. 2B is changed from that in the state shown in FIG. 2A, and due to this, light emitted from the diffraction grating 3 in a direction perpendicular to the output mirror 5 is light with a wavelength different than a wavelength in the state shown in FIG. 2A. The light with the wavelength is reflected by the output mirror 5 and amplified by the resonator, and is outputted from the output mirror 5. As such, by allowing the lens moving means 8 to be driven, the wavelength of light to be extracted can be changed.

Operations performed when the wavelength of light to be extracted is changed will be described in more detail below. First, operations performed when the integral component unit 7 is disposed in a position of FIG. 2A will be described, and then operations performed after the user of the laser device 1 allows the lens moving means 8 to be driven to move the integral component unit 7 in the x-direction, thereby moving the integral component unit 7 to a position of FIG. 2B will be described. FIG. 2A is a conceptual diagram showing the disposition position of the integral component unit 7 and an optical path in an initial state, and the x-coordinate of the integral component unit 7 is $x_0$. Any position may be used as the reference for the x-coordinate of the integral component unit 7, but here, a position where the integral component unit 7 is connected to the lens moving means 8 is used as the x-coordinate of the integral component unit 7. FIG. 2B is a conceptual diagram showing the disposition position of the integral component unit 7 and an optical path after moving the integral component unit 7 in the x-direction by $\Delta x$, and the x-coordinate of the integral component unit 7 is $x_0 + \Delta x$.

First, to produce laser oscillation in the laser device 1 shown in FIGs. 1A and 1B, current is allowed to flow through the laser element 9 using a power supply which is not shown. By injecting a certain level or more of current, the laser element 9 emits light.

The light emitted from the laser element 9 passes through the lens 10 and is thereby collimated in both the x-direction and y-direction and emitted as parallel light parallel to the z-axis.

The parallel light emitted from the lens 10 is collected by the cylindrical lens 6, and the collected light is incident on the diffraction grating 3 at an angle $\alpha_0$. Then, the diffraction grating 3 diffracts each wavelength component of the incident light in such a manner that the wavelength components reinforce each other in respective different directions. Of the wavelength components of the light diffracted by the diffraction grating 3, only light that perpendicularly enters the output mirror 5 such as that represented by a dotted line in FIG. 2A is regularly reflected by the diffraction grating 3 and returns to an incident path, and thus, the light with this wavelength is amplified by the resonator and results in a wavelength component with the highest gain of the laser element 9.

The angle of emission β of laser light emitted from the diffraction grating 3 depends on the angle of incidence α of light incident on the diffraction grating 3, the slit separation d of the diffraction grating, and the wavelength λ of the incident light, and a relationship therebetween is represented by the following grating equation when the order of diffraction is m.

[Expression 1]

$$d|sin\alpha - sin\beta| = m\lambda \cdot \cdot \cdot \quad (1)$$

In the configuration of the present embodiment, light that is perpendicularly incident on and reflected by the output mirror 5 propagates in a reverse direction along the same optical path as an optical path used upon incidence and returns to the laser element 9. Then, reflection is repeated between the rear end surface 15 of the laser element 9 and the output mirror 5, thereby producing resonance. In addition, light that is obliquely incident on the output mirror 5 does not propagate in a reverse direction along the same optical path as an incident optical path even if the light is reflected, and does not resonate. Hence, pieces of light with a wavelength diffracted by the diffraction grating 3 are amplified by the resonator in such a manner that the pieces of light reinforce each other at an angle at which the pieces of light are perpendicularly incident on the output mirror 5.

Here, to determine a wavelength of pieces of light that are diffracted by the diffraction grating 3 in such a manner that the pieces of light reinforce each other at an angle at which the pieces of light are perpendicularly incident on the output mirror 5, a case of β being $\beta_0$ in equation (1) is adopted because the diffraction grating 3 forms the angle $\beta_0$ with the output mirror 5. In addition, since the angle of incidence of light in disposition of the integral component unit 7 of FIG. 2A is $\alpha_0$, α in expression 1 is $\alpha_0$. In addition, since the diffraction grating 3 can obtain maximum diffraction efficiency in a specific order of diffraction $m_0$, m in expression 1 is $m_0$. Thus, λ obtained when $\alpha_0$ is substituted for α, $\beta_0$ for β, and $m_0$ for m in expression 1 is the wavelength of light reinforced by interference in a direction in which the light is perpendicularly incident on the output mirror 5, and λ in this case is $\lambda_0$.

Light with the wavelength $\lambda_0$ obtained in the above-described manner is emitted from the diffraction grating 3 and thereafter a part of the light is reflected by the output mirror 5. The reflected light propagates in a reverse direction along the same optical path as an incident optical path, and resonates between the rear end surface 15 of the laser element 9 and the output mirror 5. The resonant light is amplified by induced emission by the laser element 9, and the resulting amplified light with the wavelength $\lambda_0$ is outputted from the output mirror 5 to the outside of the laser device 1.

Next, operations performed after moving the integral component unit 7 in the x-direction by Δx using the lens moving means 8 will be described using FIG. 2B. FIG. 2B is a conceptual diagram showing the disposition of the integral component unit and an optical path after moving the integral component unit 7 in the x-direction by Δx. Operations performed by the laser element 9 and the lens 10 are the same as those performed before moving the integral component unit 7 and thus are omitted.

Since the integral component unit 7 has been moved, the cylindrical lens 6 included in the integral component unit 7 accordingly also moves in the x-direction by Δx, and a position on the incident surface 11 where parallel light emitted from the lens 10 is incident changes. By the change in the incident position of light on the cylindrical lens 6, an emission position of light that passes through the cylindrical lens 6 and is emitted from the emission surface 12 also changes, and the angle of emission changes depending on the emission position of the light.

Then, since the angle of the light emitted from the emission surface 12 changes, the angle of light incident on the diffraction grating 3 also changes from $\alpha_0$ to $\alpha_0+\Delta\alpha$. In this case, in expression 1, the angle of emission β remains as $\beta_0$ and only α changes from $\alpha_0$ to $\alpha_0+\Delta a$. Hence, the wavelength of light reinforced for the same order of diffraction $m_0$ changes from $\lambda_0$ to $\lambda_0+\Delta\lambda$.

Light with the wavelength $\lambda_0+\Delta\lambda$ emitted from the diffraction grating 3 resonates between the rear end surface 15 of the laser element 9 and the output mirror 5 in the same manner as before the movement of the integral component unit 7, and amplified light with the wavelength $\lambda_0+\Delta\lambda$ is outputted from the output mirror 5.

By the operations of the laser device 1 such as those described above, the user of the laser device 1 can change the wavelength of light outputted from the output mirror 5.

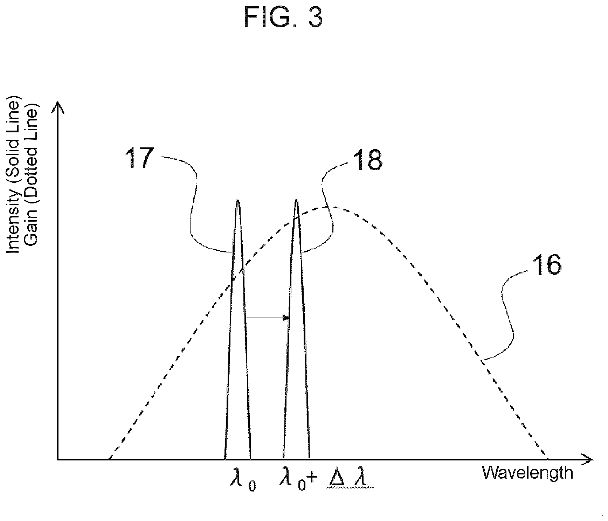

FIG. 3 is a characteristic diagram showing a gain band of the laser element 9 with respect to wavelength and output light intensity spectra upon operation of the laser device 1. In FIG. 3, a peak with a wide width represented by a dotted line is a gain band 16 of the laser element 9, and of two peaks with a narrow width shown, the left one is a spectrum 17 of light that resonates and is amplified in the laser device 1 and outputted when the laser device 1 is brought into the state of FIG. 2A, and the right one is a spectrum 18 of light that resonates and is amplified in the laser device 1 and outputted when the laser device 1 is brought into the state of FIG. 2B.

The laser element 9 has the certain gain band 16 as indicated by the dotted line in FIG. 3, and of pieces of light with wavelengths in the gain band 16, a piece of light with the wavelength λ which is determined by expression (1) on the basis of the angle of incidence α of light incident on the diffraction grating 3 resonates in the resonator, and so-called laser oscillation is produced. Here, when the x-coordinate of the integral component unit 7 is changed from $x_0$ to $x_0+\Delta x$ by moving the integral component unit 7 in the x-direction using the lens moving means 8, the wavelength of light to be outputted changes

by $\Delta\lambda$. By thus displacing the integral component unit 7 using the lens moving means 8, the wavelength of oscillation can be changed. In this case, $\Delta x$ can take both the positive and negative values in the x-direction, depending on the direction of movement of the integral component unit 7, and $\Delta\lambda$ also takes either one of the positive and negative values on the basis of the value of $\Delta x$. Hence, in the wavelengths of the gain band of the laser element 9, both of an increase in wavelength and a decrease in wavelength can be achieved from an original wavelength.

Although the laser element 9 of the present embodiment has different light emission widths and different spread angles in the x-direction and the y-direction, the role of the laser element 9 is to amplify light by induced emission and emit the amplified light, and thus, as long as light can be emitted in such a manner, the configuration is not limited to the above-described one, and for example, the laser element 9 may be configured to have the same light emission width and the same spread angle in the x-direction and the y-direction. In addition, the laser element 9 is not limited to a semiconductor laser, and for example, the laser element 9 may be configured to include a solid-state laser with a wide gain band and a semiconductor laser for pumping the solid-state laser (in terms of desirable application to the present invention).

The role of the lens 10 of the present embodiment is to allow light emitted from the laser element 9 to be incident thereon and emit parallel light, and as long as parallel light can be emitted, the shape is not limited to the above-described one. For example, the lens 10 may be formed in such a manner that the shape of the emission surface remains as it is and the shape of the incident surface is an axially-symmetric concave shape, or a normal convex lens, etc., may be used. In addition, since the lens 10 is to collimate light in both the x-direction and the y-direction in order to form a stable resonator, light does not necessarily need to be collimated in both directions using a single lens. For example, the lens 10 may be configured to include two lenses that separately collimate light in each of the x- and y-directions.

Although in the present embodiment it is configured in such a manner that the cylindrical lens is used as a lens placed after the lens 10, as long as an angle at which emission light is emitted changes depending on a position where light is incident, the configuration is not limited to the above-described one, and for example, a normal convex lens may be used without regard particularly to the cylindrical shape.

Although in the present embodiment it is configured in such a manner that a transmission diffraction grating is used as an optical element that converts incident light into emission light to be emitted in a direction based on the wavelength of the incident light, as long as incident light is converted into emission light to be emitted in a direction based on the wavelength of the incident light, the configuration is not limited to the above-described one, and for example, a configuration that uses a reflective diffraction grating or a dispersive prism may be adopted.

Second Embodiment.

Next, a laser device of a second embodiment of the present invention will be described.

The first embodiment describes a case in which the laser element 9 included in the light source unit 2 has a single light emission point, but the present embodiment describes a case in which a laser element 20 included in the light source unit 2 has a plurality of light emission points.

A configuration of the laser device of the present embodiment will be described.

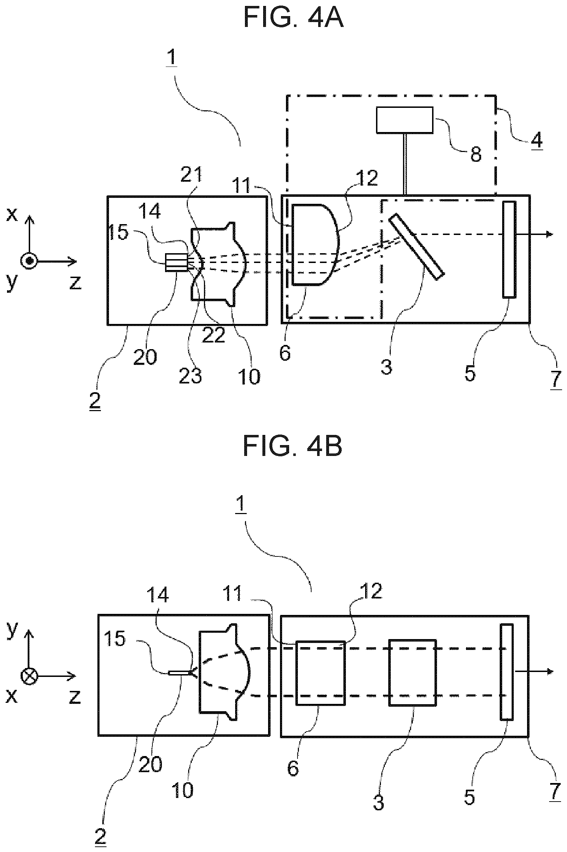

FIGs. 4A and 4B are configuration diagrams showing a configuration of a laser device 1 of the second embodiment for carrying out the present invention, and FIG. 4A is a configuration diagram of the laser device 1 as viewed from above and FIG. 4B is a configuration diagram of the laser device 1 as viewed from the side.

In the present embodiment, the laser element 20 included in the light source unit 2 has an emitter 21, an emitter 22, and an emitter 23 that are arranged in an array in an arrangement direction of the slits of the diffraction grating 3. Other components are the same as those of the first embodiment. In addition, the lens 10 that collimates light emitted from the laser element 20 is configured to collimate light using a single lens as in the first embodiment, but the lens 10 may be configured to include lenses for the respective emitters that collimate pieces of emission light.

Next, operations of the laser device 1 of the present embodiment will be described.

First, as in the first embodiment, to produce laser oscillation in the laser device 1, current is allowed to flow through the laser element 20 using a power supply which is not shown. When a certain level or more of current flows through the laser element 20, pieces of light are emitted from the respective emitters 21, 22, and 23 of the laser element 20, and three rays of light outputted from the respective emitters are emitted from the laser element 20.

The pieces of light emitted from the laser element 20 are collimated by the lens 10, and parallel light is incident on the cylindrical lens 6. Since the incident positions of the pieces of light emitted from the respective emitters on the incident surface 11 of the cylindrical lens 6 differ from each other, the angles of pieces of light to be emitted from the emission surface 12 also differ from each other.

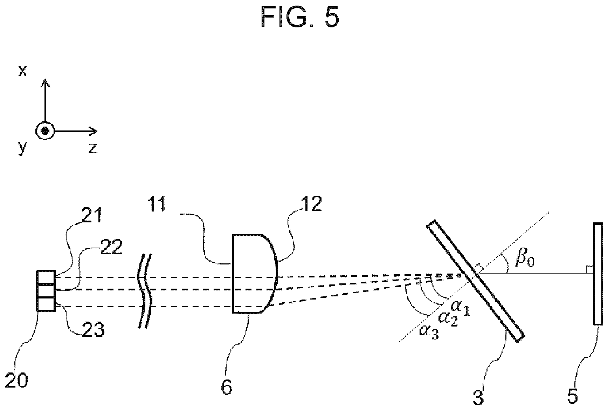

FIG. 5 is an explanatory diagram showing the states of main parts upon operation of the laser device 1 according to the second embodiment.

As shown in FIG. 5, three rays of light emitted from the cylindrical lens 6 at respective different angles of emission are incident on the diffraction grating 3 at respective different angles of incidence. Here, the angles of incidence of the rays of light emitted from the emitter 21, the emitter 22, and the emitter 23 on the diffraction grating 3 are $\alpha_1$, $\alpha_2$, and $\alpha_3$, respectively. As in the first embodiment, the diffraction grating 3 diffracts each wavelength component of incident light in such a manner that the wavelength components reinforce each other in respective different directions, in accordance with equation (1). When it is assumed, as in the first embodiment, that the angle formed by the diffraction grating 3 and the output mirror is $\beta_0$ and the diffraction grating 3 can obtain maximum diffraction efficiency in a specific order of diffraction $m_0$, $\lambda$ obtained when $\beta_0$ is substituted for $\beta$, $m_0$ for m, and each of $\alpha_1$, $\alpha_2$, and $\alpha_3$ for $\alpha$ in equation (1) is the wavelength of light reinforced by interference in a direction in which the light is perpendicularly incident on the output mirror 5. It is assumed that $\lambda$s obtained when $\alpha_1$, $\alpha_2$, and $\alpha_3$ are substituted for $\alpha$ are $\lambda_1$, $\lambda_2$, and $\lambda_3$, respectively.

Pieces of light with the wavelengths $\lambda_1$, $\lambda_2$, and $\lambda_3$ obtained by the diffraction grating 3 as described above are emitted from the diffraction grating 3 and then, as in the first embodiment, a part of the pieces of light is reflected by the output mirror 5. The pieces of reflected light propagate in a reverse direction along the same optical paths as incident optical paths, and resonate between the rear end surface 15 of the laser element 9 and the output mirror 5. The pieces of resonant light are amplified by induced emission by the laser element 20, and the pieces of resulting amplified light with the wavelengths $\lambda_1$, $\lambda_2$, and $\lambda_3$, i.e., multiple-wavelength laser light, are outputted from the output mirror 5 to the outside of the laser device 1.

Next, operations performed after moving the integral component unit 7 in the x-direction by $\Delta x$ using the lens moving means 8 will be described. As in the first embodiment, by moving the integral component unit 7, the cylindrical lens 6 included in the integral component unit 7 also moves in the x-direction by $\Delta x$, and positions on the incident surface 11 where pieces of parallel light emitted from the lens 10 are incident change. By the change in the incident positions of pieces of light on the cylindrical lens 6, emission positions of pieces of light that pass through the cylindrical lens 6 and are emitted from the emission surface 12 also change, and the angles of emission change depending on the emission positions of the pieces of light.

Then, since the angles of the pieces of light emitted from the emission surface 12 change, the angles of pieces of light incident on the diffraction grating 3 also change from $\alpha_1$, $\alpha_2$, and as to $\alpha_1+\Delta\alpha_1$, $\alpha_2+\Delta\alpha_2$, and $\alpha_3+\Delta\alpha_3$. In this case, in equation (1), the angle of emission $\beta$ remains as $\beta_0$ and only $\alpha$ changes from $\alpha_1$, $\alpha_2$, and as to $\alpha_1+A\alpha_1$, $\alpha_2+\Delta\alpha_2$, and $\alpha_3+\Delta\alpha_3$. Hence, the wavelengths of pieces of light reinforced for the same order of diffraction $m_0$ change from $\lambda_1$, $\lambda_2$, and $\lambda_3$ to $\lambda_1+\Delta\lambda_1$, $\lambda_2+\Delta\lambda_2$, and $\lambda_3+\Delta\lambda_3$.

Pieces of light with the wavelengths $\lambda_1+\Delta\lambda_1$, $\lambda_2+\Delta\lambda_2$, and $\lambda_3+\Delta\lambda_3$ emitted from the diffraction grating 3 resonate between the rear end surface 15 of the laser element 9 and the output mirror 5 in the same manner as before the movement of the integral component unit 7, and pieces of amplified light with the wavelengths $\lambda_1+\Delta\lambda_1$, $\lambda_2+\Delta\lambda_2$, and $\lambda_3+\Delta\lambda_3$ are outputted from the output mirror 5.

By the operations of the laser device 1 such as those described above, the user of the laser device 1 can change the wavelengths of pieces of light outputted from the output mirror 5.

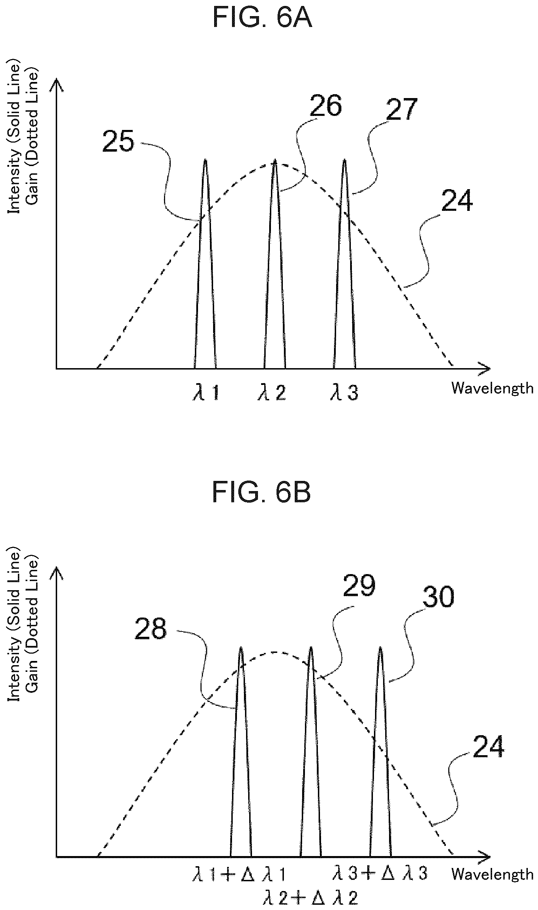

FIGs. 6A and 6B are characteristic diagrams showing a gain band of the laser element 20 with respect to wavelength and output light intensity spectra upon operation of the laser device 1. FIG. 6A is a conceptual diagram for a state before moving the integral component unit, and FIG. 6B is a conceptual diagram for a state after moving the integral component unit. In FIG. 6A, a peak with a wide width represented by a dotted line is a gain band 24 of the laser element 20, and three peaks with a narrow width represented by solid lines are, from left to right, a spectrum 25, a spectrum 26, and a spectrum 27 of pieces of light, respectively, that are emitted from the emitter 21, the emitter 22, and the emitter 23, resonate and are amplified and outputted. In addition, in FIG. 6B, a peak with a wide width represented by a dotted line is the gain band 24 of the laser element 20, and three peaks with a narrow width represented by solid lines are, from left to right, a spectrum 28, a spectrum 29, and a spectrum 30 of pieces of light, respectively, that are emitted from the emitter 21, the emitter 22, and the emitter 23, resonate and are amplified and outputted. As in the first embodiment, both of an increase in wavelength and a decrease in wavelength can be achieved from an original wavelength as long as the wavelength is in the gain band of the laser element 20.

When the laser device of the present embodiment is applied to a product such as a projector, coherency of laser light which is remarkable in a single wavelength decreases due to achievement of multiple wavelengths, and a projector with suppressed speckle noise can be implemented. To suppress speckle in a conventional projector, an optical system after a laser light source requires special measures, but if the laser device of the present embodiment is used, then such special measures are not required.

Although the laser element 20 of the present embodiment is configured to have three emitters, as long as the laser element 20 has a plurality of emitters, the configuration is not limited to the above-described one, and for example, a laser element having a larger number of emitters arranged therein in an array may be used. In terms of a reduction in coherency, achievement of multiple wavelengths by an increase in the number of light emission points greatly contributes to a reduction in speckle.

Although the light source unit 2 of the present embodiment is configured to include a single laser element having a plurality of light emission points, as long as a plurality of rays of light can be obtained, the configuration is not limited to the above-described one, and for example, the light source unit 2 may be configured to include a plurality of laser elements each having a single light emission point or configured to include a plurality of laser elements each having a plurality of light emission points.

Third Embodiment.

Next, a laser device of a third embodiment of the present invention will be described.

The laser device of the present embodiment is characterized in that lens moving means allows an integral component unit to slightly vibrate.

A configuration of a laser device 1 of the present embodiment will be described.

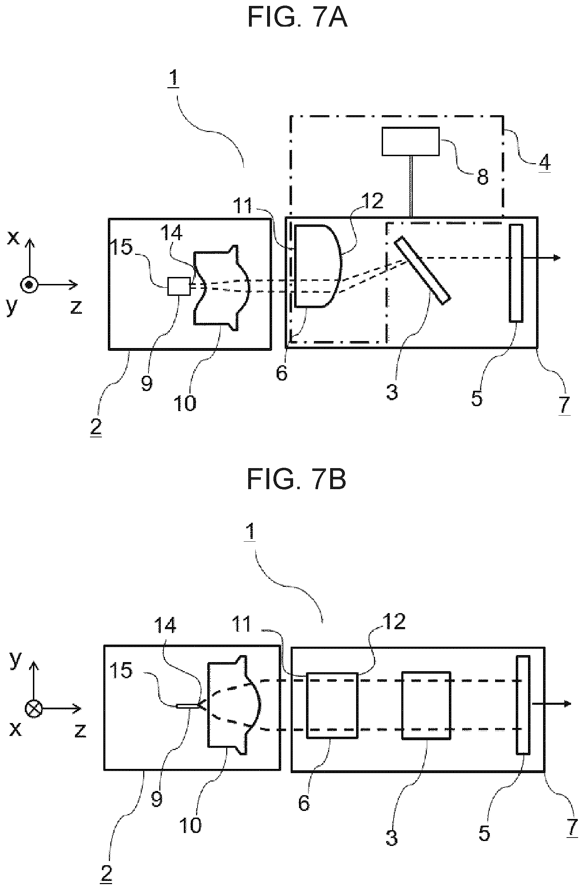

FIGs. 7A and 7B are configuration diagrams showing a configuration of the laser device 1 of the third embodiment for carrying out the present invention, and FIG. 7A is a configuration diagram of the laser device 1 as viewed from above and FIG. 7B is a configuration diagram of the laser device 1 as viewed from the side.

The angle-of-incidence changing means 4 included in the laser device 1 of the present embodiment includes lens moving means 31. The lens moving means 31 allows the integral component unit 7 to slightly vibrate in the x-direction and is, for example, a motor, etc., but is not limited to a motor and may be any means as long as the means can allow the integral component unit 7 to slightly vibrate in the x-direction. Other components are the same as those of the first embodiment.

Next, operations of the laser device 1 of the present embodiment will be described.

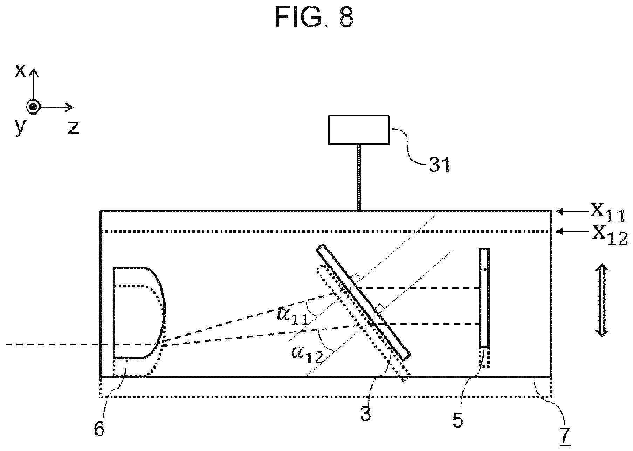

FIG. 8 is an explanatory diagram showing the states of main parts upon operation of the laser device 1 according to the third embodiment and showing the position of the integral component unit 7 when the integral component unit 7 slightly vibrates, and solid lines show a state in which the integral component unit 7 has moved to the farthest position in a positive direction of the x-axis, and dotted lines show a state in which the integral component unit 7 has moved to the farthest position in a negative direction of the x-axis.

The lens moving means 31 allows the integral component unit 7 to slightly vibrate in the x-direction at a vibration width between $x_{11}$ and $x_{12}$. It is assumed that the angles of incidence of light on the diffraction grating 3 in states in which the integral component unit 7 is located at $x_{11}$ and $x_{12}$ are $\alpha_{11}$ and $\alpha_{12}$, respectively. In addition, it is assumed that as in the above-described other embodiments, the diffraction grating 3 and the output mirror 5 form an angle $\beta_0$ and the diffraction grating 3 can obtain maximum diffraction efficiency in a specific order of diffraction $m_0$. It is assumed that $\lambda$ obtained when $\beta_0$ is substituted for $\beta$, $m_0$ for m, and each of $\alpha_{11}$ and $\alpha_{12}$ for $\alpha$ in equation (1) are $\lambda_{11}$ and $\lambda_{12}$, respectively.

As in the other embodiments, light emitted from the diffraction grating 3 resonates and is amplified between the rear end surface 15 of the laser element 9 and the output mirror 5, and is then outputted from the output mirror 5 to the outside of the laser device 1. The wavelength of the light outputted at this time is a wavelength based on the position of the integral component unit 7 and is a wavelength between $\lambda_{11}$ and $\lambda_{12}$.

Since the integral component unit 7 is allowed to slightly vibrate by the lens moving means 31, while the wavelength of light to be outputted quickly changes between $\lambda_{11}$ and $\lambda_{12}$, the light is outputted to the outside of the laser device.

It is said that generally the human eyes and brain cannot recognize image flicker when the image flicker cycle is smaller than about 20 msec to 50 msec. Images in that period of time are subjected to an integration process and averaged and recognized by the brain. Thus, when the laser device 1 of the present embodiment is applied to a projector, etc., by changing the wavelength of light in a short period of time, the luminance and colors of images to be recognized are averaged, and the averaging can be performed to the extent that speckle noise does not bother humans.

Note that in all of the above-described embodiments, it is configured in such a manner that the lens moving means is used as the angle-of-incidence changing means for changing an angle at which light emitted from the light source unit is incident on the optical element. However, the angle-of-incidence changing means is not limited to the above-described configuration as long as the angle-of-incidence changing means can change the angle of light incident on the optical element, and for example, the angle-of-incidence changing means may be configured to allow the optical element to rotate without moving the lens. For example, by providing, as the angle-of-incidence changing means, diffraction grating rotating means for allowing the diffraction grating to rotate or dispersive prism rotating means for allowing a dispersive prism to rotate in the laser device, the angle of incidence of light incident on those means is changed, and with the change in the angle of incidence, the wavelength of emission light is changed and the same advantageous effects as those of the above-described embodiments can be obtained. In this case, the diffraction grating rotating means allows the diffraction grating to rotate, with the extending direction of the slits of the diffraction grating being a rotational axis. In addition, when, for example, the dispersive prism is a triangular prism whose bottom is a triangle, the dispersive prism rotating means allows the dispersive prism to rotate, with a straight line perpendicular to the bottom being a rotational axis.

In addition, the angle-of-incidence changing means may be lens rotating means for allowing the lens to rotate. By allowing the cylindrical lens 6 to rotate without changing the position or angle of the optical element, the angle of incidence of light incident on the diffraction grating 3 is changed and the wavelength of light emitted from the laser device 1 can be changed.

In addition, when, as in the second embodiment, the light source unit includes a plurality of laser elements, the angle-of-incidence changing means may be an emission position selecting unit that selects a laser element that emits light among the plurality of laser elements. In this case, by selecting a laser element that is allowed to emit light among the plurality of laser elements, the wavelength of laser light emitted from the laser device can be changed without using the angle-of-incidence changing means or the rotating means. Pieces of light emitted from the plurality of laser elements provided are incident on the incident surface 11 of the cylindrical lens 6 at respective different incident positions. The pieces of light incident on the respective different incident positions are emitted from the emission surface 12 at respective different emission positions and at respective different angles of emission, and are accordingly incident on the diffraction grating 3 at respective different angles of incidence. By selecting a laser element that emits light among the plurality of laser elements provided, the angle of incidence of light incident on the diffraction grating 3 can be selected, and light with a wavelength based on the selected laser element and the angle of incidence is outputted from the laser device 1. Hence, by changing selection of a laser element that emits light, the angle of incidence of light incident on the diffraction grating 3 is changed and the wavelength of light outputted from the laser device 1 can be changed.

INDUSTRIAL APPLICABILITY

Laser devices according to the present invention can be applied to projectors, lighting devices, etc.

REFERENCE SIGNS LIST

1: laser device, 2: light source unit, 3: diffraction grating, 4: angle-of-incidence changing means, 5: output mirror, 6: cylindrical lens, 7: integral component unit, 8: lens moving means, 9: laser element, 10: lens, 11: incident surface, 12: emission surface, 14: front end surface, 15: rear end surface, 16: gain band, 17: spectrum, 18: spectrum, 20: laser element, 21: emitter, 22: emitter, 23: emitter, 24: gain band, 25: spectrum, 26: spectrum, 27: spectrum, 28: spectrum, 29: spectrum, 30: spectrum, 31: lens moving means

**Claims**

1. A laser device comprising:

   a light source unit (2) provided with a laser element (9) for emitting laser light by forming a laser resonator with an output mirror (5), the laser element (9) having a rear end surface on which a reflective film is formed;
   an optical element (3) for determining a wavelength of oscillation emitted from the laser element (9), on a basis of an angle of the laser light incident on the optical element (3), the optical element being (3) disposed in an optical path of the laser light emitted from the light source unit (2), between said laser element (9) and said output mirror (5);
the output mirror (5) configured to reflect a part of emission light emitted from the optical element (3) toward the optical element (3); and
angle-of-incidence changing means (4) for changing an angle at which the light emitted from the light source unit (2) is incident on the optical element (3), wherein
the output mirror (5) configured to allow another part of the light than the reflected light reflected toward the optical element (3), which is a part of the emitted light emitted from the optical element (3) to pass therethrough and outputs the other part of the light to the outside of the laser device,
the light source unit (2) includes a first lens (10) for refracting the light emitted from the laser element (9) to emit parallel light, and
the angle-of-incidence changing means (4) includes a second lens (6) having an incident surface (11) whose area is larger than an emission area of the light emitted from the first lens (10), the second lens (6) allowing the light emitted from the first lens (10) to be incident on the incident surface (11) to collect the light; and lens moving means (8, 31) configured to change the angle of the light incident on the incident surface (11) by allowing the second lens (6) to move to change an incident position, on the incident surface (11), of the light emitted from the first lens (10),
**characterized in that** the laser device comprises an integral component unit (7) in which the second lens (6), the optical element (3), and the output mirror (5) are formed into one unit, and wherein the lens moving means (8, 31) are configured to allow the integral component unit (7) to move in a perpendicular direction to a direction in which the output mirror (5) outputs the light outside the laser device, by which the second lens (6) is configured to move in a perpendicular direction to a direction in which the output mirror (5) outputs a light outside the laser device, and the incident position changes.

2. The laser device according to claim 1, wherein the lens moving means (31) allows the second lens (6) to vibrate.

3. The laser device according to claim 1 or claim 2, wherein
the optical element (3) is a diffraction grating (3) for diffracting each wavelength component of the incident laser light in such a manner that the wavelength components reinforce each other in respective different directions, the diffraction grating (3) having a plurality of slits.

4. The laser device according to claim 3, wherein the light source unit(2) includes a plurality of laser elements (9) arranged in an arrangement direction of the slits.

5. The laser device according to claim 3 or claim 4, wherein the laser element (9) provided in the light source unit (2) has a plurality of light emission points arranged in an arrangement direction of the slits.

6. The laser device according to claim 1, wherein the optical element (3) is a dispersive prism for dispersing and emitting wavelength components of the incident laser light in respective different directions.

7. The laser device according to any one of claims 1 to 6, wherein the first lens (10) has an incident surface with cylindrically concave shape and an emission surface with axially-symmetric convex shape.

8. The laser device according to any one of claims 1 to 6, wherein the first lens (10) comprises two lenses separately collimating a light in two different directions perpendicular and parallel to the direction in which the output mirror (5) outputs light outside the laser device.

9. The laser device according to any one of claims 1 to 6, wherein the second lens (6) is a cylindrical lens.

**Patentansprüche**

1. Laservorrichtung, umfassend:

   eine Lichtquelleneinheit (2), die mit einem Laserelement (9) zum Emittieren von Laserlicht durch Bilden eines Laserresonators mit einem Ausgangsspiegel (5) versehen ist, wobei das Laserelement (9) eine hintere Endfläche aufweist, auf der ein reflektierender Film gebildet ist;
   ein optisches Element (3) zum Bestimmen einer Wellenlänge der von dem Laserelement (9) emittierten Schwingung auf der Grundlage eines Winkels des auf das optische Element (3) einfallenden Laserlichts, wobei das optische Element (3) in einem optischen Pfad des von der Lichtquelleneinheit (2) emittierten Laserlichts zwischen dem Laserelement (9) und dem Ausgangsspiegel (5) angeordnet ist;
   den Ausgangsspiegel (5), der eingerichtet ist, einen Teil des von dem optischen Element (3) emittierten Emissionslichts zu dem optischen Element (3) zu reflektieren; und
   eine Einfallswinkel-Änderungseinrichtung (4) zum Ändern eines Winkels, unter dem das von der Lichtquelleneinheit (2) emittierte Licht auf das optische Element (3) einfällt, wobei
   der Ausgangsspiegel (5) eingerichtet ist, dass er einen anderen Teil des Lichts als das zum optischen Element (3) reflektierte Licht, das ein Teil des vom optischen Element (3) emittierten Lichts ist, durchlässt und den anderen Teil des Lichts nach außerhalb der Laservorrichtung ausgibt,
   die Lichtquelleneinheit (2) eine erste Linse (10) zur Brechung des von dem Laserelement (9) emittierten Lichts enthält, um paralleles Licht zu emittieren, und
   die Einfallswinkel-Änderungseinrichtung (4) eine zweite Linse (6) mit einer Einfallsfläche (11) aufweist, deren Fläche größer ist als eine Emissionsfläche des von der ersten Linse (10) emittierten Lichts, wobei die zweite Linse (6) ermöglicht, dass das von der ersten Linse (10) emittierte Licht auf die Einfallsfläche (11) einfällt, um das Licht zu sammeln; und eine Linsenbewegungseinrichtung (8, 31), eingerichtet ist, den Winkel des auf die Einfallsfläche (11) einfallenden Lichts zu ändern, indem sie der zweiten Linse (6) ermöglicht, sich zu bewegen, um eine Einfallposition des von der ersten Linse (10) emittierten Lichts auf der Einfallsfläche (11) zu ändern,
   **dadurch gekennzeichnet, dass** die Laservorrichtung eine integrale Komponenteneinheit (7) umfasst, in der die zweite Linse (6), das optische Element (3) und der Ausgangsspiegel (5) zu einer Einheit ausgebildet sind, und wobei die Linsenbewegungseinrichtung (8, 31) eingerichtet sind, der integralen Komponenteneinheit (7) zu ermöglichen, sich in einer senkrechten Richtung zu einer Richtung zu bewegen, in der der Ausgangsspiegel das Licht außerhalb der Laservorrichtung ausgibt, wodurch die zweite Linse (6) eingerichtet ist, sich in einer senkrechten Richtung zu einer Richtung zu bewegen, in der der Ausgangsspiegel (5) ein Licht außerhalb der Laservorrichtung ausgibt, und sich die Einfallsposition ändert.

2. Laservorrichtung nach Anspruch 1, wobei die Linsenbewegungseinrichtung (31) die zweite Linse (6) vibrieren lässt.

3. Laservorrichtung nach Anspruch 1 oder Anspruch 2, wobei

das optische Element (3) ein Beugungsgitter (3) ist, um jede Wellenlängenkomponente des einfallenden Laserlichts so zu beugen, dass sich die Wellenlängenkomponenten in jeweils unterschiedlichen Richtungen gegenseitig verstärken, wobei das Beugungsgitter (3) eine Vielzahl von Schlitzen aufweist.

4. Laservorrichtung nach Anspruch 3, wobei die Lichtquelleneinheit (2) eine Vielzahl von Laserelementen (9) umfasst, die in einer Anordnungsrichtung der Schlitze angeordnet sind.

5. Laservorrichtung nach Anspruch 3 oder Anspruch 4, wobei das in der Lichtquelleneinheit (2) vorgesehene Laserelement (9) eine Mehrzahl von in einer Anordnungsrichtung der Schlitze angeordneten Lichtemissionspunkten aufweist.

6. Laservorrichtung nach Anspruch 1, wobei das optische Element (3) ein dispersives Prisma zur Dispersion und Emission von Wellenlängenkomponenten des einfallenden Laserlichts in jeweils unterschiedliche Richtungen ist.

7. Laservorrichtung nach einem der Ansprüche 1 bis 6, wobei die erste Linse (10) eine zylindrisch konkave Einfallsfläche und eine axialsymmetrisch konvexe Emissionsfläche aufweist.

8. Laservorrichtung nach einem der Ansprüche 1 bis 6, wobei die erste Linse (10) zwei Linsen umfasst, die getrennt ein Licht in zwei verschiedenen Richtungen kollimieren, die senkrecht und parallel zu der Richtung verlaufen, in der der Ausgangsspiegel (5) Licht aus der Laservorrichtung ausgibt.

9. Laservorrichtung nach einem der Ansprüche 1 bis 6, wobei die zweite Linse (6) eine Zylinderlinse ist.

**Revendications**

1. Dispositif laser comprenant :

une unité source de lumière (2) dotée d'un élément laser (9), destinée à émettre une lumière laser en formant un résonateur laser avec un miroir de sortie (5), l'élément laser (9) présentant une surface extrémité arrière sur laquelle est formé un film réfléchissant ;
un élément optique (3) destiné à déterminer la longueur d'onde d'oscillation émise par l'élément laser (9), sur la base de l'angle d'incidence de la lumière laser sur l'élément optique (3), l'élément optique (3) étant disposé dans le chemin optique de la lumière laser émise par l'unité source de lumière (2), entre ledit élément laser (9) et ledit miroir de sortie (5) ;
le miroir de sortie (5) est configuré pour réfléchir une partie de la lumière d'émission émise par l'élément optique (3) vers l'élément optique (3) ; et
des moyens de modification d'angle d'incidence (4) destinés à modifier l'angle d'incidence de la lumière émise par l'unité source de lumière (2) sur l'élément optique (3),
dans lequel le miroir de sortie (5) est configuré pour permettre à une partie de la lumière autre que la lumière réfléchie, réfléchie vers l'élément optique (3), qui est une partie de la lumière émise, émise par l'élément optique (3), de passer à travers, et délivre en sortie l'autre partie de la lumière vers l'extérieur du dispositif laser,
l'unité de source de lumière (2) comprend une première lentille (10) destinée à réfracter la lumière émise par l'élément laser (9), pour émettre une lumière parallèle, et
les moyens de modification d'angle d'incidence (4) comprennent une seconde lentille (6) qui présente une surface d'incidence (11) dont la surface est supérieure à la surface d'émission de la lumière émise par la première lentille (10), la seconde lentille (6) permettant à la lumière émise par la première lentille (10) d'être incidente sur la surface d'incidence (11) pour collecter la lumière ; et des moyens de déplacement de lentille (8, 31), configurés pour modifier l'angle d'incidence de la lumière sur la surface d'incidence (11), en permettant à la seconde lentille (6) de se déplacer pour modifier une position d'incidence, sur la surface d'incidence (11), de la lumière émise par la première lentille (10),
caractérisé en ce quele dispositif laser comprend une unité composant d'une pièce (7) dans laquelle la seconde lentille (6), l'élément optique (3) et le miroir de sortie (5), sont formés en une seule unité, et dans lequel les moyens de déplacement de lentille (8, 31) sont configurés pour permettre à l'unité composant d'une pièce (7) de se déplacer dans une direction perpendiculaire à la direction dans laquelle le miroir de sortie (5) délivre en sortie la lumière à l'extérieur du dispositif laser, grâce à quoi la seconde lentille (6) est configurée pour se déplacer dans une direction perpendiculaire à la direction dans laquelle le miroir de sortie (5) délivre en sortie une lumière à l'extérieur du dispositif laser, et la position d'incidence est modifiée.

2. Dispositif laser selon la revendication 1, dans lequel les moyens de déplacement de lentille (31) permettent à la seconde lentille (6) de vibrer.

**3.** Dispositif laser selon la revendication 1 ou la revendication 2, dans lequel
l'élément optique (3) est un réseau de diffraction (3), destiné à diffracter chaque composante de longueur d'onde de la lumière d'incidence laser de telle manière que les composantes de longueurs d'onde se renforcent les unes les autres dans des directions différentes respectives, le réseau de diffraction (3) présentant une pluralité de fentes.

**4.** Dispositif laser selon la revendication 3, dans lequel l'unité source de lumière (2) comprend une pluralité d'éléments lasers (9) agencés dans la direction d'agencement des fentes.

**5.** Dispositif laser selon la revendication 3 ou la revendication 4, dans lequel
l'élément laser (9) disposé dans l'unité source de lumière (2), présente une pluralité de points d'émission de la lumière, agencés dans la direction d'agencement des fentes.

**6.** Dispositif laser selon la revendication 1, dans lequel l'élément optique (3) est un prisme dispersif, destiné à disperser et à émettre des composantes de longueurs d'onde de la lumière d'incidence laser dans différentes directions respectives.

**7.** Dispositif laser selon l'une quelconque des revendications 1 à 6, dans lequel
la première lentille (10) présente une surface d'incidence de forme concave cylindrique, et une surface d'émission de forme convexe à symétrie axiale.

**8.** Dispositif laser selon l'une quelconque des revendications 1 à 6, dans lequel
la première lentille (10) comprend deux lentilles qui effectuent séparément la collimation de la lumière dans deux directions différentes, perpendiculaire et parallèle, à la direction dans laquelle le miroir de sortie (5) délivre en sortie la lumière à l'extérieur du dispositif laser.

**9.** Dispositif laser selon l'une quelconque des revendications 1 à 6, dans lequel
la seconde lentille (6) est une lentille cylindrique.

## FIG. 1A

## FIG. 1B

# FIG. 2A

# FIG. 2B

# FIG. 3

# FIG. 4A

# FIG. 4B

# FIG. 5

# FIG. 6A

# FIG. 6B

# FIG. 7A

# FIG. 7B

FIG. 8

**EP 3 855 586 B1**

REFERENCES CITED IN THE DESCRIPTION

**Patent documents cited in the description**

- JP 2013044800 A
- JP 6165366 B
- US 2018026425 A1
- JP 2008130805 A
- JP 2015072955 A
- US 2006227821 A1